Europäisches Patentamt

European Patent Office

Office européen des brevets

(11) Publication number: 0 478 108 A1

# EUROPEAN PATENT APPLICATION

(21) Application number: 91304794.0

(22) Date of filing: 28.05.91

(51) Int. Cl.5: H01L 21/00

(30) Priority: 24.09.90 US 587010

(43) Date of publication of application:
01.04.92 Bulletin 92/14

(84) Designated Contracting States:
AT BE CH DE DK ES FR GB GR IT LI LU NL SE

(71) Applicant: MACHINE TECHNOLOGY INC.
25 Eastmans Road
Parsippany New Jersey 07054(US)

(72) Inventor: Hillman, Gary
15 Goodhart Drive
Livingston, New Jersey 07039(US)

(74) Representative: Beresford, Keith Denis Lewis
et al
BERESFORD & Co. 2-5 Warwick Court High
Holborn
London WC1R 5DJ(GB)

(54) Wafer transfer device.

(57) A transfer apparatus and method for transferring a wafer from one location to another in a controlled environment. The apparatus includes a movable member (108) for supporting a wafer thereon, which member (108) is operative for transferring the wafer from one location to another. The apparatus is characterized by environment control means (120) connected to the member (108) for maintaining the wafer in a controlled environment while transferring the wafer from one location to another independent of the environment surrounding the member (108).

The environmental control means (120) in accordance with one embodiment includes a first shroud (124) overlying a portion of the member (108) to provide a chamber (136) for receiving the wafer, and a second shroud (128) overlying and spaced from the first shroud (124) to provide a passageway (132) therebetween. A first supply means (146, 150) is provided in communication with the chamber (136) for supplying a gas therein and a second supply means (138) is provided in communication with the passageway (132) for supplying a gas therein.

F I G. 2

The present invention relates in general to a wafer transfer device, and more particularly, to a positionable wafer transfer arm which is especially adapted for transferring semiconductor wafers from one location to another in a controlled gaseous environment independent of the surrounding environment in connection with the processing of wafers in a multiple module processing apparatus therefor.

In semiconductor wafer processing, it has become essential to provide dust-free or ultra-clean manufacturing conditions with the increase of integration density of the semiconductor devices and with the increase of process resolution therefore. This is particularly important in fabricating the dense, complex and contamination sensitive LSI and VLSI integrated circuit structures. The problem of wafer contamination has become more significant as semiconductor processing increasingly relies upon modular processing system design for greater efficiency and system flexibility. These modular processing systems permit the plural arrangement of independent, self-contained process modules in a plurality of track and/or branch configurations, each module being independently replaceable as a stand alone unit with a module adapted to perform the same or different function or operation. This modularity necessitates the handling and transferring of individual wafers from one process module to another, typically within the surrounding environment.

Equipment for providing clean environmental conditions in semiconductor processing systems is accordingly important for contamination-free wafer handling. One known system for providing a clean environment which has heretofore been employed extensively is called an entire downflow system. In this system, air passing through a fine dust particle removal filter is caused to flow through the wafer processing room so that air in the room is cleaned by circulation with the incoming clean air. In this system, however, a large quantity of expensive filters are used to cause circulation of clean air through the entire processing room along with its associated costs. There is also known from Tamura et al., U.S. Patent No. 4,923,352 and Lazzari et al., U.S. Patent No. 4,851,018 transporting systems for plural semiconductor wafers using filtered clean air in a processing room of less cleanliness. In these aforementioned systems, in addition to the increased expenses of providing clean filtered air, an upper limit is imposed on the cleanliness of the so-called clean air which can have an adverse affect in the fabrication of LSI/VLSI integrated circuit structures.

It is also known to control particulate contamination by the use of vacuum load lock mechanisms which provide wafer loading and off-loading, as well as wafer transfer in a vacuum. See, for example, Layman et al, U.S. Patent No. 4,764,076, Bramhall, Jr. et al., U.S. Patent No. 4,923,584, Stark et al., U.S. Patent No. 4,917,556, Eror et al., U.S. Patent No. 4,915,564 and Strahl et al., U.S. Patent No. 4,717,461. However, the incorporation of vacuum chambers and load lock mechanisms is relatively expensive, as well as limiting the semiconductor processing system to a dedicated configuration eliminating the modular configuration so often desired.

Broadly, in accordance with the present invention, there is provided a wafer transfer device which is adapted for wafer loading and off-loading, as well as transferring wafers from one process station or module to another, in a controlled gaseous environment independent of the environment surrounding the transfer device.

In accordance with one embodiment of the present invention, there is provided a transfer apparatus for transferring a wafer from one location to another in a controlled environment, the apparatus including a movable member for supporting a wafer thereon, the member operative for transferring the wafer from one location to another, the apparatus characterized by environment control means connected to the member for maintaining the wafer in a controlled environment while transferring the wafer from one location to another independent of the environment surrounding the member.

In accordance with another embodiment of the present invention, there is provided a method of transferring a wafer from one location to another in a controlled environment by supporting a wafer on a movable member operative for transferring the wafer from one location to another, the method characterized by providing a gas stream flowing over the surface of the wafer to maintain the wafer in a controlled environment while transferring the wafer from one location to another independent of the environment surrounding the member.

In order that the invention may be fully understood, it will now be described with reference to the accompanying drawings, in which:

FIG. 1 is a block diagrammatic illustration showing a modular semiconductor processing system incorporating a wafer transfer device in accordance with the present invention.

FIG. 2 is a partial cross-sectional view of the transfer device in accordance with one embodiment of the present invention in operative association with a semiconductor wafer during transfer from one location to another.

FIG. 3 is a partial cross-sectional view of a portion of a transfer device in accordance with another embodiment of the present invention.

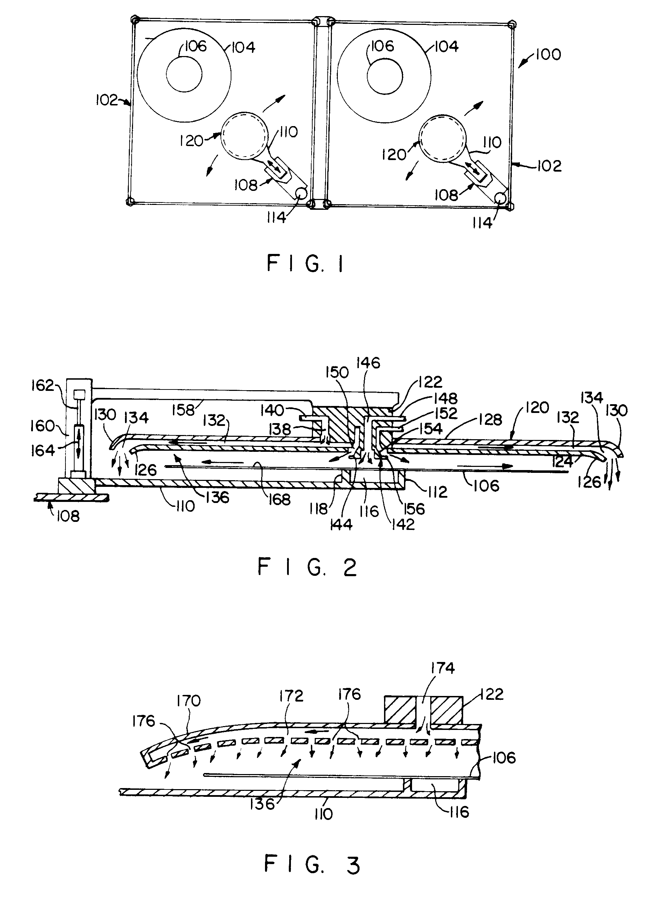

Referring now to the drawings, wherein like reference numerals represent like elements, there is shown in FIG. 1 a modular processing system generally designated by reference number 100. The system 100 includes a plurality of modular processing apparatuses 102 each containing a process module 104 configured to perform at least one processing function or operation on a semiconductor wafer 106 being transferred along a linear or circular track or one having multiple branches. For example, the process modules 104 may be adapted to perform any one or a variety of dedicated functions or operations such as coating, CVD and PVD depositing, baking, developing, scrubbing, buffering, inspecting, plasma etching, exposing to ultraviolet light, storing in an elevator cassette, transporting and the like. These process modules 104 are known in the semiconductor processing industry and will accordingly not be described herein. Each modular processing apparatus 102 may therefore be designed as an independent, self-contained processing modular unit adapted to perform a specified dedicated function or operation on the wafer 106 being processed. Each process module 104 will further include its own CPU (not shown) and additional distributive processing capability such that the modular processing apparatus 102 can be operated as such a stand alone processing modular unit or connected with other process modules to configure a modular process system 100 therefrom.

In the modular processing system 100, there is further included a main CPU (not shown) which is programmed to control the sequence of wafer 106 handling and transport. The main CPU performs the primary programmed operation of controlling the modular processing system 100 as a system. In addition, as previously described, each process module 104 includes its own CPU and additional distributing process capabilities. As such, each processing module 104 is provided with a communications link which is connected to an adjacent process module to establish control communications therebetween, as well as to the main CPU. The communications link between the process modules 104 sets up the proper time sequences for the operation of the individual process modules under control of the main CPU by, for example, signaling the adjacent process module that the designated function or operation being performed has been completed. The particular programming for the operation of a particular modular processing system 100 is not within the scope of the present invention and, in any event, can be provided using conventional programming techniques once the desired sequence and functions or operations of the modular processing system have been established. A more detailed description of a modular processing system 100 and the construction of the individual process modules 104 is disclosed in U.S. Patent No. 4,852,516.

Certain ones, if not all, of the processing apparatuses 102 are provided with a wafer transport device 108. The transfer device 108 is constructed generally of an extendable arm assembly 110, for example, one that includes a plurality of telescopic members having its free end 112 (see FIG. 2) configured for releasably engaging a wafer 106 and its other end attached to an indexing and rotating mechanism 114. As shown in FIG. 2, the free end 112 of the extendable arm assembly 110 includes a vacuum chamber 116 formed by a surrounding upstanding wall 118. The vacuum chamber 116 is connected to a vacuum source (not shown) for releasably securing the semiconductor wafer 106 to the extendable arm assembly 110. The specific construction of the wafer transfer device 108, as thus far described, is generally known in the semiconductor industry, and will therefore not be described further. One such known wafer transfer device 108 is available from Machine Technology, Inc. of Parsippany, New Jersey sold under the registered trademark FlexiArm. See also Strahl et al., U.S. Patent No. 4,717,461.

As previously described, there is the desirable need to maintain the wafer 106 in a particle or contamination-free environment while being transferred, for example, from one process module 104 to another. In addition, it may also be desirable to maintain the wafer 106 in a particular gas environment compatible with the processes being conducted at one or more process modules 104 while the semiconductor wafer is being transferred therebetween as to be described hereinafter.

Referring again to FIG. 2, there is shown in accordance with the present invention, a wafer transfer device 108 having an environment control device generally designated by reference numeral 120 which is connected to the extendable arm assembly 110. The environment control device 120 includes a support block 122 to which there is secured a first dish-shaped shroud 124 having a downwardly turned circumferential portion 126 and a second shroud 128 also having a downwardly turned circumferential portion 130. The second shroud 128 is arranged overlying and spaced from the first shroud 124 to provide a passageway 132 therebetween which terminates at the downwardly turned circumferential portions 126, 130 at an annular opening 134. The first shroud 124 provides a wafer receiving chamber generally designated by reference numeral 136 as to be described hereinafter.

The support block 122 is provided with an internal bore 138 having one end opening in communication with passageway 132 and another end opening in communication with a gas source (not shown) by means of tubing 140. The support block 122 further includes an integral fitting generally designated by reference number 142. The fitting 142 includes an annular member 144 which provides a central bore 146 having a downwardly directed end opening in communication with wafer receiving chamber 136 and another end opening in communication with a source of gas (not shown) by means of tubing 148. The annular member 144 in cooperation with a portion of the support block 122 provides an annular bore 150 having one end opening in communication with the wafer receiving chamber 136 and another end opening in communication with a gas source (not shown) by means of tubing 152. The lower end of the fitting 142 extends into the wafer receiving chamber 136 and is provided with a circumferential inclined wall 154 and ledge 156 which direct the opening of the annular bore 150 in a generally radially outward direction.

The support block 122 is connected to an extension support arm 158 which is coupled to a lifting mechanism 160 which, in turn, is connected to a portion of the extendable arm assembly 110. The lifting mechanism 160 may include an air piston assembly 162 which, when operated, will cause the extension support arm 158 to reciprocally raise in a vertical direction as indicated by arrow 164. The construction of a particular air piston assembly 162 to effect the vertical displacement of the extension support arm 158 is generally known and is therefore not further described herein.

The operation of the environment control device 120 in accordance with the present invention will now be described. By way of example, the wafer transfer device 108 is arranged for transferring a semiconductor wafer 106 from one process module 104 to another while maintaining the wafer in a controlled clean gas flow, and hence, a particle and contamination-free environment. This is particularly useful when transferring a wafer 106 from a photoresist coating module to a photoresist baking module so as to prevent particles or other contamination from adhering to the photoresist layer which would ultimately adversely affect the resulting integrated circuits being fabricated within the wafer. It is also to be understood, as previously described, that the environment control device 120 has particular utility when transferring a wafer 106 between process modules 104 where other processes are being performed, such as between a wafer cleaning module and a photoresist coating module and the like.

A wafer 106 to be transferred, such as one within a process module 104, is releasably secured to the wafer transfer device 108 at its free end 112 by application of vacuum to the vacuum chamber 116. This is achieved by extending the extendable arm assembly 110 so as to engage the underside of the wafer 106 at its respective position within the process module 104. The wafer 106 when secured to the extendable arm assembly 110 is received within the wafer receiving chamber 136 provided by the environment control device 120. To facilitate engagement of the wafer 106 by the extendable arm assembly 110, the environment control device 120 may be lifted vertically by means of the lifting mechanism 160. Once the wafer 106 is secured to the wafer transfer device 108, the lifting mechanism 160 is reactivated to place the environment control device 120 in its position overlying the wafer so as to be contained within the wafer receiving chamber 136.

Since the environment control device 120 is supported by the extendable arm assembly 110, the device will be moved simultaneously with the assembly in registration with the secured wafer 106 as it is being transferred from one location to another, such as between process modules 104. It is also contemplated that the wafer 106 may be secured to the wafer transfer device 108 without manipulation of the lifting mechanism 160. In this regard, it is noted that the downwardly turned circumferential portion 126 of the first shroud 124 is displaced above the surface 168 of the wafer 106. The wafer 106 may therefore be laterally inserted into the wafer receiving chamber 136 and overlying the upstanding wall 118 without lifting of the environment control device 120. However, in the event of possible interference with a process module 104, it might be necessary to activate the lifting mechanism 160 to provide clearance for receiving the wafer 106.

The wafer 106 is maintained in a particle and contamination-free environment, independent of the environment surrounding the wafer transfer device 108 by providing a continuous flow of clean gas through one or more of the supply tubings 140, 148 or 152. In accordance with the preferred embodiment, a continuous gas flow, such as an inert gas of nitrogen, argon, and the like is fed through the annual bore 150 to be discharged into the wafer receiving cavity 136 by means of the fitting 142 in the form of a radially outward gas flow over the wafer surface 168 as generally designated by the arrows. The created gas flow over the wafer surface 168 within the wafer receiving chamber 136 is effective to prevent contamination of the wafer surface by means of particulate material or other forms of contaminates.

In addition to the radial gas flow as thus far described, it is also contemplated to supply a continuous gas flow through central bore 146 in a generally downward direction so as to impinge upon the wafer surface 168 at a generally central location. The impinging gas flow may be used either alone or in conjunction with the radial gas flow created by the annular bore 150. A gas barrier surrounding the wafer receiving chamber 136 may be created by providing a gas flow through bore 138, and radially outward through passageway 132 as indicated by the arrows and downwardly through the annular opening 134, as also designated by the arrows. The downwardly directed barrier gas flow creates a curtain or wall surrounding the wafer receiving chamber 136 which contains the wafer 106. In supplying the various gas flows as thus far described, it is to be understood that the same or different gases may be employed as may be desired.

Referring to FIG. 3, there is disclosed a partial cross-sectional view of a wafer transfer device 108 constructed in accordance with another embodiment of the present invention. In this regard, the wafer transfer device 108 includes a shroud 170 having a hollow interior 172 which is arranged in fluid communication with a source of gas (not shown) through bore 174 provided within support block 122. The inwardly facing surface of shroud 170 is provided with a plurality of openings 176 through which the supplied gas will flow in a sprinkler or shower head effect to fill the wafer receiving chamber 136 and to bath the wafer 106 in a similar manner as previously described with respect to the embodiment illustrated in Fig. 2. The ,penings 176 may be provided in an array of various patterns and ones having the same or different diameter as desired to provide a continuous clean gas flow into wafer receiving chamber 136.

The wafer 106, once secured to the wafer transfer device 108 within the environment control device 120, may be transferred to another process module 104 by indexing and/or rotating the wafer transfer device by means of the indexing and rotating mechanism 114 until the wafer overlies the central portion of the adjacent process module. The wafer 106 is removed from the wafer transfer device 108 in a reverse process as thus far described so as to be received within the next process module 104. The wafer transfer device 108 may be retracted and indexed or rotated back to its initial position if desired for receiving another wafer 106 from the adjacent process module 104. In this manner, individual wafers 106 may be transferred between adjacent process modules 104 to perform sequential processing operations thereon free of environmental contamination.

The environment control device 120 has thus far been described as maintaining an environment which is free of particulate matter or other contaminates during transfer of the wafer 106 from one location to another. However, it is to be understood that although inert gases have been employed for this purpose, such inert gases may be used to prevent undesirable oxidation of the silicone wafer material subsequent to etching of the wafer in a process module 104. Previously, the etched semiconductor wafer 106 would be maintained in a vacuum to prevent oxidation.

## Claims

1. A transfer apparatus for transferring a wafer from one location to another in a controlled environment, said apparatus including a movable member (108) for supporting a wafer thereon, said member (108) operative for transferring said wafer from one location to another, said apparatus characterized by environment control means (120) connected to said member (108) for maintaining said wafer in a controlled environment while transferring said wafer from one location to another independent of the environment surrounding said member (108).

2. The apparatus of claim 1, characterized in that said environmental control means (120) includes a shroud (124, 170) overlying a portion of said member (108) to provide a chamber (136) for receiving said wafer.

3. The apparatus of claim 2, characterized in that said environment control means (120) includes supply means (146, 150) in communication with said chamber (136) for supplying a gas therein.

4. The apparatus of claim 3, characterized in that said supply means (146, 150) is arranged in alignment with the center of said wafer when supported by said member (108).

5. The apparatus of claim 3 or 4, characterized in that said supply means (146, 150) provides a gas stream flowing radially outward over the surface of said wafer.

6. The apparatus in accordance with any one of the preceding claims, characterized in that said environmental control means (120) includes a first shroud (124) overlying a portion of said member (108) to provide a chamber (136) for receiving said wafer, and a second shroud (128) overlying and spaced from said first shroud (124) to provide a passageway (132) therebetween.

7. The apparatus of claim 6, characterized in that said environmental control means (120) includes first supply means (146, 150) in communication with said chamber (136) for supplying a gas therein, and second supply means (138) in communication with said passageway (132) for supplying a gas therein.

8. The apparatus of claim 6 or 7, characterized in that said passageway (132) terminates at an annular opening (134) surrounding said chamber (136), whereby a gas flowing through said passageway (132) emerges in a downward direction to provide a gas barrier between said chamber (136) and the surrounding environment.

9. The apparatus of claim 1, 2, 3 or 4, characterized in that said environment control means (120) includes a first shroud (170) having a hollow interior (172) and a plurality of openings (176) providing fluid communication with a chamber (136) formed by said first shroud (170) for supplying said gas thereto.

10. The apparatus according to any one of the preceding claims, characterized in that said movable member (108) includes a longitudinally-extending arm (110) having means (116) for releasably securing said wafer to one end thereof (112).

11. The apparatus according to any one of the preceding claims, characterized by a first station (102) having processing means (104) for performing at least one operation on a wafer to be processed, and a receiving station (102) for receiving the processed wafer, said member (108) transferring said wafer between said first station (102) and said receiving station (102) in said controlled environment.

12. The apparatus of claim 11, characterized by processing means (104) at said receiving station (102) for performing at least another operation on said wafer.

13. A method of transferring a wafer from one location to another in a controlled environment by supporting a wafer on a movable member (108) operative for transferring said wafer from one location to another, said method characterized by providing a gas stream flowing over the surface of said wafer to maintain said wafer in a controlled environment while transferring said wafer from one location to another independent of the environment surrounding said member (108).

14. The method of claim 13, characterized by positioning a shroud (124, 170) overlying a portion of said member (108) to provide a chamber (136) for receiving said wafer and said gas stream.

15. The method of claim 13 or 14, characterized by providing said gas stream flowing radially outward over the surface of said wafer.

16. The method of claim 13, 14 or 15, characterized by positioning a first shroud (124) overlying a portion of said member (108) to provide a chamber (136) for receiving said wafer, and positioning a second shroud (128) overlying and spaced from said first shroud to provide a passageway (132) therebetween.

17. The method of claim 16, characterized by supplying a gas to said chamber (136) and said passageway (132).

18. The method of claim 17, characterized by terminating said passageway (132) at an annular opening (134) surrounding said chamber (136), and providing a gas barrier between said chamber (136) and the surrounding environment by the gas flowing through said passageway (132) emerging in a downward direction at said annular opening (134).

19. The method of claim 13, 14 or 15 further including positioning a shroud (170) overlying a portion of said member (108) to provide a chamber (136) for receiving said wafer, said shroud including a hollow interior (172) and a plurality of openings (176) providing fluid communication with said chamber (136), and supplying a gas through said openings (176) from said hollow interior (172) into said chamber (136) over the surface of said wafer.

F I G. 1

F I G. 2

F I G. 3

European
Patent Office

EUROPEAN SEARCH
REPORT

Application Number

EP 91 30 4794

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 201 240 (KABUSHIKI KAISHA SEIBU GIKEN) * page 6; figures 6-8 * * | 1-5,9, 13-15,19 | H 01 L 21/00 |
| | – – – | | |
| D,A | EP-A-0 246 798 (MACHINE TECHNOLOGY INC.) * column 8, line 44 - column 9, line 34; figure 7 * * | 1 | |
| | – – – – – | | |

TECHNICAL FIELDS
SEARCHED (Int. Cl.5)

H 01 L

The present search report has been drawn up for all claims

| Place of search | Date of completion of search | Examiner |
|---|---|---|
| The Hague | 09 January 92 | BOLDER G.J.A. |

CATEGORY OF CITED DOCUMENTS

X : particularly relevant if taken alone
Y : particularly relevant if combined with another
   document of the same catagory
A : technological background
O : non-written disclosure
P : intermediate document
T : theory or principle underlying the invention

E : earlier patent document, but published on, or after
   the filing date
D : document cited in the application
L : document cited for other reasons

&: member of the same patent family, corresponding
   document